# EUROPÄISCHE PATENTSCHRIFT

(11) **EP 0 750 351 B1**
(45) Veröffentlichungstag und Bekanntmachung des Hinweises auf die Patenterteilung: **09.04.2003**
(21) Anmeldenummer: 96109350.7
(22) Anmeldetag: 10.06.1996
(51) Int. Cl.: H01L 29/739, H01L 29/78, H01L 29/06

(54) **MOS-Halbleiterbauelement mit verbesserten Durchlasseigenschaften**
MOS semiconductor device with improved m-characteristics
Dispositif semi-conducteur de type MOS avec des caractéristiques à l'état passant améliorées

(30) Priorität: 19.06.1995 DE 19522161
(43) Veröffentlichungstag der Anmeldung: 27.12.1996
(73) Patentinhaber: Infineon Technologies AG, 81669 München (DE)
(72) Erfinder: Brunner, Heinrich, Dr., 81667 München (DE)
(74) Vertreter: Patentanwälte Westphal, Mussgnug & Partner

(56) Entgegenhaltungen:
- EP-A- 0 407 011
- EP-A- 0 615 292
- DE-A- 4 113 756
- DE-A- 4 315 723
- US-A- 4 862 232
- US-A- 4 901 124
- US-A- 5 396 087
- PATENT ABSTRACTS OF JAPAN vol. 017, no. 356 (E-1394), 6.Juli 1993 & JP 05 055594 A (NEC CORP), 5.März 1993,

## Beschreibung

Bei planaren und nicht planare MOS-Halbleiterstrukturen, wie beispielsweise MOSFET und IGBT (Isolated Gate Bipolar Transistor) ist der sogenannte On-Widerstand eine wichtige Kenngröße für die Durchlaßverluste. Als On-Widerstand eines MOS-Halbleiterbauelements wird der gesamte Widerstand zwischen Source- und Drainzone im Durchlaßzustand bezeichnet. Der On-Widerstand ist bestimmt durch einen Kanalwiderstand im MOS-FET-Kanal, einen parasitärer Junction-FET-Effekt der p-Wanne und einen Bahnwiderstand der n-Basis. Der Effekt des parasitären Junction-FET wird folgendermaßen erklärt: Der Übergang von p- zu n-Basis ist während des Durchlaßzustandes in Sperrichtung gepolt, es bildet sich eine Raumladungszone, wodurch der Strompfad der Elektronen von Source nach Drain eingeschnürt wird. Eine Erhöhung des On-Widerstandes ist die Folge.

Aus Solid-State Electronics Vol. 37, No. 3, pp. 507-514, 1994, ist ein Trench-IGBT bekannt, bei dem der Kanalwiderstand durch einen vertikalen Löcherstrom gegenüber konventionellen IGBTs deutlich reduziert ist und bei dem das der dadurch erzeugte Potentialunterschied parallel zum Kanal verläuft wodurch kein latch-up mehr entsteht.

Aus Jpn. J. Appl. Phys. Vol 33 (1994) pp. 563-566, Part 1, No. 1B, January 1994, ist ein IGBT bekannt, bei dem ein latch-up durch eine tiefe p⁺-Ionenimplantation unter eine n⁺-Source unterdrückt wird.

Aus der deutschen Offenlegungsschrift DE 43 15 723 A1 ist ein MOS-Bauelement bekannt, bei dem aus dem Halbleiterchip zur Kathode abfließende Minoritätsträger direkt über den neben der Gateelektrode liegenden Teil der Basiszone zur Sourceelektrode abfließen und dadurch das Einschalten eines parasitären Bipolartransistors vermeiden. Hierbei sind eine erste und zweite Basiszone bis auf Übergangsbereiche durch ein Gateoxid getrennt, das die Gateelektrodenteile umgibt.

Aus der europäischen Patentanmeldung 0 407 011 A2 ist ein Halbleiterbauelement mit isoliertem Gate und einer Grabenstruktur bekannt.

Aus der europäischen Patentanmeldung 0 615 292 A2 ist ferner ein IGBT bekannt, bei dem ein parasitärer Thyristor durch eine Potentialbarriere für Majoritätsträger in der Kollektorschicht im Bereich der angrenzenden Basisschicht erzeugt wird.

Aus dem US-Patent 4,901,124 ist schließlich ein leitfähigkeitsmoldulierter MOSFET bekannt, der aus einem MOSFET in SOI-Technik und einem Bipolartransistor im Halbleitersubstrat gebildet ist, Elektronen und Löcher unterschiedliche Wege nehmen und deshalb keine parasitären Thyristoren auftreten.

Die der Erfindung zugrundeliegende Aufgabe besteht nun darin, ein MOS-Halbleiterbauelement anzugeben, bei dem eine Erhöhung des On-Widerstandes aufgrund des parasitären Junciton-FET-Effekts möglichst vermieden wird. Diese Aufgabe wird erfindungsgemäß durch die Merkmale des Patentanspruchs 1 gelöst.

Die Ansprüche 2 bis 4 sind auf vorteilhafte Weiterbildungen der Erfindung gerichtet, wobei bei der Weiterbildung nach Anspruch 3 vorteilhafterweise ein Einschalten einer im MOS-Halbleiterbauelement vorhandenen parasitären Bipolarstruktur (Latch-up) verhindert wird.

Die Erfindung wird im folgenden anhand der Zeichnungen näher erläutert.Dabei zeigt:
- Figur 1: einen Trench-IGBT nach dem Stand der Technik,
- Figur 2: eine erste Ausführungsform eines erfindungsgemäßen Trench-IGBTs,
- Figur 3: eine zweite Ausführungsform eines erfindungsgemäßen Trench-IGBTs,
- Figur 4: ein Beispiel einer Ausgestaltung einer Zellenstruktur eines IGBTs, das dem besseren Verständnis der Erfindung dient,
- Figur 5: eine vorteilhafte Ausgestaltung der Zellenstruktur des erfindungsgemäßen IGBTs nach Figur 2 und 3,
- Figur 6: einen Aufbau eines erfindungsgemäßen Planar-IGBTs,
- Figur 7: eine vorteilhafte Ausgestaltung der Kathodenstruktur des erfindungsgemäßen IGBTs nach Figur 6,
- Figur 8: eine Darstellung der Ladungsträgerkonzentration im Durchlaß aufgetragen über die vertikale Ortskoordinate in der p-Wannenmitte für Trench-IGBTs nach Figur 1, 2 und 3 und
- Figur 9: eine Darstellung des Durchlaßstromes in Abhängigkeit der Durchlaßspannung für einen Trench-IGBT nach Figur 1, 2 und 3.

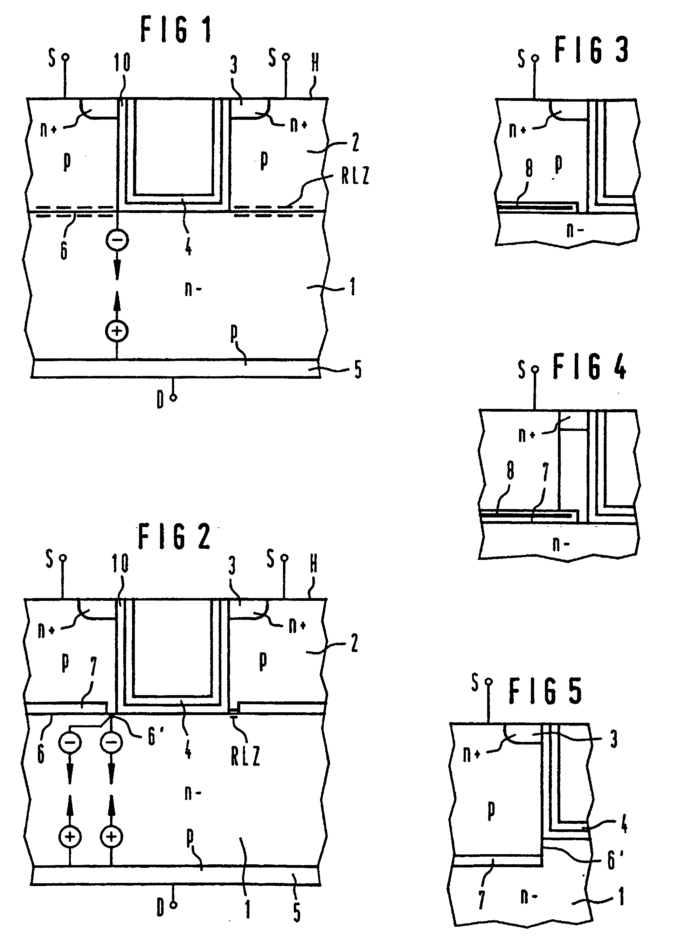

Ein Trench-IGBT nach dem Stand der Technik, wie er in Figur 1 dargestellt ist, hat einen Halbleiterkörper mit einer schwach n-dotierten Basiszone 1. In die n-Basis 1 ist eine p-dotierte Basiszone 2 eingebettet. In diese p-Basis ist eine n-dotierte Sourcezone 3 eingelagert. Eine Gateelektrode 4 ist durch eine Isolierschicht 10 von der p-Basis 2, der n-Basis 1 und der n-Sourcezone 3 elektrisch getrennt.

Beim Anlegen einer positiven Spannung an die Gateelektrode 4 entsteht in der p-Basis 2 ein n-leitender Kanal (Inversionsschicht), der die n-Sourcezone mit der n-Basiszone elektrisch leitend verbindet. Die n-Sourceelektrode und die p-Basiszone sind über einen Sourceanschluß S kontaktiert. An die n-Basiszone grenzt drainseitig eine stärker dotierte p-Zone 5 an, welche elektrisch mit dem Drainanschluß D verbunden ist.

Wird an den Anschluß D eine positive Spannung angelegt, so fließen bei positiver Gatespannung, Elektronen von der Sourcezone 3 über die n-Basis 1 zur p-Zone 5. Der drainseitige p-Emitter 5 wird von den Elektronen angesteuert und es werden Löcher in die n-Basis 1 injiziert, welche über die p-Basis 2 zum Sourceanschluß S hin abfließen. Durch die Löcherinjektion wird die n-Basis 1 mit Ladungsträgern überschwemmt, dadurch kommt es zur Leitfähigkeitsmodulation des n-Basiswiderstandes. Im Durchlaßzustand ist am pn-Übergang 6 das Potential drainseitig höher als sourceseitig, deshalb ist der pn-Übergang 6 in Sperrichtung gepolt. Durch den Aufbau einer Raumladungszone RLZ kommt es dort im Durchlaßzustand zu einer Absenkung der Konzentration der freien Ladungsträger. Dadurch wird die Leitfähigkeitsmodulation in der n-Basis 1 reduziert, dies führt zu einer Erhöhung des On-Widerstandes. Der IGBT in Figur 1 besitzt eine parasitäre Thyristorstruktur, welche aus der n-Source-Zone 3 der p-Basis 2 und der n-Basis 1 und dem p-Emitter 5 gebildet wird. Erzeugt der unter der n-Sourcezone 3 in Querrichtung fließende Löcherstrom am Übergang zwischen n-Sourcezone 3 und p-Basis 2 einen Spannungsabfall, der größer als die Schwellenspannung ist, so werden Elektronen von der n-Sourcezone 3 in die p-Basis 2 injiziert. In diesem Zustand wird der parasitäre Thyristor eingeschaltet und das Bauelement kann nicht mehr durch die Spannung an der Gateelektrode 4 gesteuert werden.

Ein erfindungsgemäßer IGBT nach Figur 2 besitzt zwischen p-und n-Basis eine Isolierschicht 7, so daß die p-Basis 2 und die n-Basis 1 nur über einen schmalen Bereich 6' elektrisch verbunden sind, wobei der Bereich 6' vorteilhafterweise zwischen 100 und 1000 nm breit ist. Die laterale Ausbildung der Raumladungszone RLZ ist auf den schmalen Bereich 6' beschränkt. Die kathodenseitige Absenkung der Ladungsträgerkonzentration an der Grenzschicht 6 zwischen der Isolierschicht 7 und der n-Basis 1 wird aufgehoben.

Besteht die Isolierschicht 7 aus einer Oxidschicht, so kann diese beispielsweise bei Implantation hergestellt werden.

In Figur 3 ist unter anderem eine Isolierschicht 7 dargestellt in die eine zusätzliche Elektrode 8 eingelagert ist, wobei die Isolierschicht vorteilhafterweise zwischen 400 und 900 nm und die Elektrode zwischen 200 und 500 nm dick ist. Die Isolierschicht 7 besteht beispielsweise aus SiO₂ und die Elektrode 8 kann beispielsweise aus Polysilizium hergestellt werden. Die Elektrode 8 kann dabei wahlweise mit der Elektrode 4 elektrisch verbunden sein.

Im Durchlaßzustand bildet sich bei einer positiven Polung der Elektrode 8 an der Grenzschicht 6 eine Akuumulationsschicht aus, welche zu einer Anhebung der Ladungsträgerkonzentration in der n-Basis 1 führt.

Figur 4 zeigt ein Beispiel einer Ausgestaltung einer Zellenstruktur eines IGBTs, das dem besseren Verständnis der Erfindung dient. In Figur 4 grenzt der Sourceanschluß S bis an die Isolierschicht 7 an. Der Löcherstrom wird hierbei oberhalb der Isolierschicht 7 vom Sourcekontakt S abgesaugt und fließt folglich nicht neben dem n-Source-Gebiet 3 ab. Eine Injektion von Elektronen der n-Source-Zone 3 unterbleibt somit. Ein Einschalten des parasitären Thyristors (Latch-up), welcher aus der Vierschichtstruktur n-Sourcezone 3, p-Basis 2, n-Basis 1 und p-Emitter 5 besteht, wird dadurch vermieden.

Die Source-Elektrode S kann wahlweise lateral mit der Kante der Isolierschicht 7 abschließen.

In Figur 2 wird die Raumladungszone sowohl von der p-Zone 2 als auch von der Isolierzone 7 gestoppt. Feldspitzen am Übergang von der p-Basis 2 zur Isolierschicht 7 können die Durchbruchsspannung reduzieren.

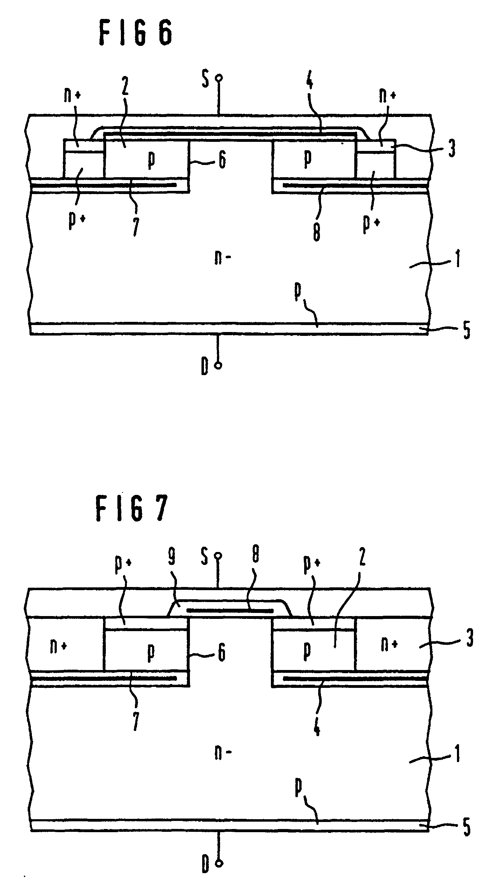

In Figur 5 ist eine vorteilhafte Ausgestaltung der Erfindung gezeigt, bei der der pn-Übergang des Bereichs 6' vertikal verläuft und die Isolierschicht 7 sowie die Gateelektrode 4 sich horizontal überlappen, wobei der Bereich 6 vorteilhafterweise zwischen 400 und 900 nm breit ist. Im Sperrzustand wird die Raumladungszone durch die Isolierschicht gestoppt und nicht durch den Bereich 6', wodurch die Gefahr der Feldspitzen reduziert wird. Wird die Isolierschicht 7 als Siliziumoxid hergestellt, so besitzt sie eine ca. 100-fach höhere Durchbruchsfeldstärke als Silizium und wirkt sich deshalb vorteilhaft auf die Sperrspannung des erfindungsgemäßen MOS-Halbleiterbauelements aus.

In Figur 6 ist das erfindungsgemäße MOS-Halbleiterbauelement in planarer Struktur ausgeführt. Durch die Isolierschicht 7 wird ein vertikales Ausbreiten der Raumladungszone zwischen p-Zone 2 und n-Zone 1 im Durchlaßzustand vermieden, wodurch eine Verbesserung des On-Widerstandes bewirkt wird. Für die weitere Reduktion des On-Widerstandes ist in der Isolierschicht 7 die Einbettung der Elektrode 8 vorgesehen, welche bei positiver Polung eine Akkumulationsschicht erzeugt.

In Figur 7 ist ein erfindungsgemäßer planarer IGBT gezeigt, dessen Gateelektrode 4 in die Isolierschicht 7 eingebettet ist. Der Inversionskanal liegt zwischen p-Schicht 2 und Isolierschicht 7. Die aus der n-Basis 1 kommenden Minoritätsträger fließen direkt über die p-Basis vom Sourceanschluß S ab. Ein Einschalten des parasitären Bipolartransistors kann daher vorteilhafterweise nicht auftreten. Die Elektrode 8 ist in die Isolierschicht 9 eingebettet. Im Durchlaßzustand ist die Elektrode 8 positiv gepolt. Die Akkumulationsschicht am Übergang von Isolierschicht 9 zur n-Basis 1 führt zu einer Anhebung der Ladungsträgerkonzentration in der n-Basis 1 und damit zu einer Verbesserung des Durchlaßwiderstandes (On-Widerstand).

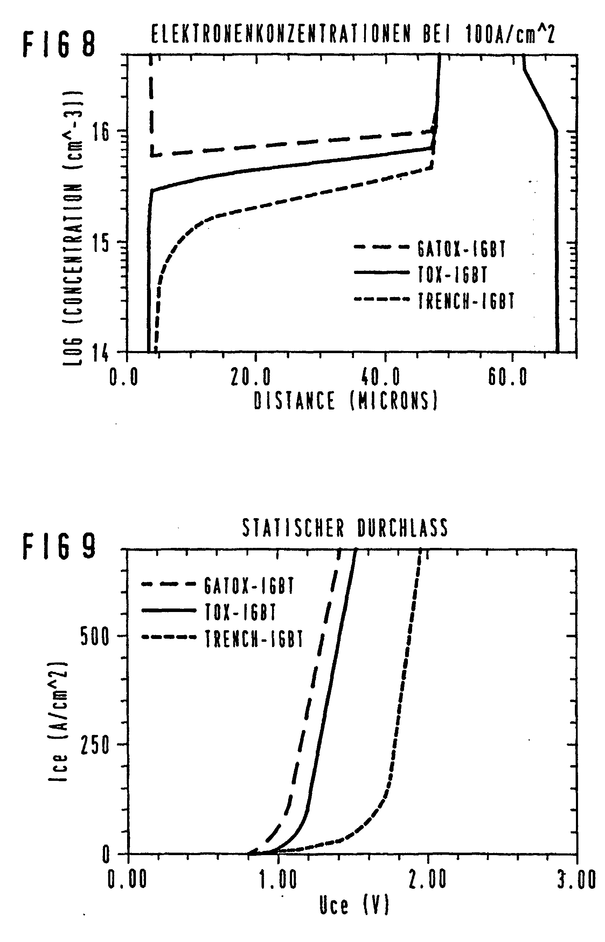

In Figur 8 sind Ladungsträgerverteilungen für den bekannten IGBT von Figur 1 und die beiden erfindungsgemäßen IGBTs der Figuren 2 und 3 bei einem Durchlaßstrom von 100 A/cm² gezeigt.

Der Effekt der Isolierschicht 7 besteht darin, daß am Übergang 6 zwischen der Isolierschicht und der n-Basis keine Raumladungszone RLZ auftritt und dadurch dort die Ladungstr&gerkonzentration der freien Ladungsträger in der n-Basis 1 nicht reduziert wird.

Die positive Polung der Elektrode 8 erzeugt eine Akkumulationsschicht und erhöht zusätzlich die Ladungsträgerkonzentration in der n-Basis 1.

In Figur 9 sind die Durchlaßkennlinien des Drain-Source-Stroms I_{ce} gezeigt. Der technische Vorteil besteht in einem im Vergleich zum bekannten IGBT geringeren Spannungsabfall, der bei einer Drain-Source-Stromdichte zwischen 100 A/cm² bei der in Figur 2 dargestellten Ausführungsform des erfindungsgemäßen IGBTs eine Reduzierung des Spannungsabfalls um 0,5 Volt und beim Ausführungsbeispiel des erfindungsgemäßen IGBTs nach Figur 3 einen um 0,65 Volt geringeren Spannungsabfall als der bekannte IGBT aufweist.

Das geschilderte Prinzip kann neben den oben beispielhaft geschilderten IGBTs auch für U-MOS- und V-MOS-Feldeffekttransistoren zur Anwendung kommen, wobei hierbei gegenüber dem IGBT im wesentlichen nur das drainseitige p-Emittergebiet 5 fehlt und der Drainanschluß D direkt mit der n-Basis 1 verbunden ist.

## Patentansprüche

1. MOS-Halbleiterbauelement mit einem Sourcegebiet (3) eines ersten Leitungstyps, einem Basisgebiet (2) eines zweiten Leitungstyps, die beide gemeinsam mit einem Sourceanschluß (S) verbunden sind und einen gemeinsamen pn-Übergang aufweisen,
mit einem Basisgebiet (1) des ersten Leitfähigkeitstyps, das einen pn-Übergang (6, 6') mit dem Basisgebiet des zweiten Leitfähigkeitstyps aufweist, und
einer Gateelektrode (G, 4), die nur durch eine Gateoxidschicht (10) vom Basisgebiet (1) des ersten Leitfähigkeitstyps und vom Basisgebiet (2) des zweiten Leitfähigkeitsgebiets getrennt ist, und bei dem die Basisschicht (1) des ersten Leitungstyps durch eine Basisisolierschicht (7) bis auf einen schmalen Übergang (6') zwischen dieser Isolierschicht (7) und der Gateoxidschicht (10) vom Basisgebiet (2) des zweiten Leitfähigkeitstyps getrennt ist.

2. MOS-Halbleiterbauelement nach Anspruch 1,
bei dem in die Basisisolierschicht (7) eine elektrisch leitende Elektrode (8) derart eingebracht ist, daß die Elektrode (8) gegenüber allen Gebieten des Halbleiters isoliert ist.

3. MOS-Halbleiterbauelement nach Anspruch 2,
bei dem die Sourceelektrode (S) direkt an die Basisisolierschicht (7) grenzt und die Elektrode (8) nur durch die Basisisolierschicht (7) von der Sourceelektrode (S) getrennt ist.

4. MOS-Halbleiterbauelement nach einem der vorhergehenden Ansprüche, bei dem der Übergang (6') zwischen dem Basisgebiet (1) des ersten Leitungstyps und dem Basisgebiet (2) des zweiten Leitungstyps bezogen auf eine horizontale Hauptfläche (H) des MOS-Halbleiterelements in vertikaler Richtung verläuft.

## Claims

1. A MOS semiconductor device having a source zone (3) of a first conduction type, a base zone (2) of a second conduction type, which are both jointly connected to a source connection (S) and have a common pn junction,
having a base zone (1) of the first conductivity type, which has a pn junction (6, 6') with the base zone of the second conductivity type, and
a gate electrode (G, 4), which is separated from the base zone (1) of the first conductivity type and from the base zone (2) of the second conductivity type only by a gate oxide layer (10), and in which the base layer (1) of the first conductivity type is separated from the base zone (2) of the second conductivity type by a base insulating layer (7) except for a narrow junction (6') between this insulating layer (7) and the gate oxide layer (10).

2. A MOS semiconductor device according to Claim 1, in which an electrically conductive electrode (8) is introduced into the base insulating layer (7) in such a manner that the electrode (8) is insulated from all zones of the semiconductor.

3. A MOS semiconductor device according to Claim 2, in which the source electrode (S) is directly adjacent to the base insulating layer (7) and the electrode (8) is only separated from the source electrode (S) by the base insulating layer (7).

4. A MOS semiconductor device according to one of the preceding Claims, in which the junction (6') between the base zone (1) of the first conduction type and the base zone (2) of the second conduction type runs in the vertical direction in relation to a horizontal main surface (H) of the MOS semiconductor device.

## Revendications

1. Élément semi-conducteur MOS avec une zone source (3) d'un premier type de conduction, avec une zone de base (2) d'un deuxième type de conduction qui toutes deux sont conjointement reliées à un raccord de source (S) et présentent un passage p-n commun,
avec une zone de base (1) du premier type de conduction laquelle présente un passage p-n (6, 6') avec la zone de base du deuxième type de conduction et
avec une électrode de porte (G, 4) qui n'est séparée de la zone de base (1) du premier type de conduction et de la zone de base (2) du deuxième type de conduction que par une couche d'oxyde de porte (10), et pour lequel la zone de base (1) du premier type de conduction est séparée de la zone de base (2) du deuxième type de conduction par une couche d'isolation de base (7) excepté un passage (6') étroit entre cette couche d'isolation (7) et la couche d'oxyde de porte (10).

2. Élément semi-conducteur MOS selon la revendication 1,
pour lequel
dans la couche d'isolation de base (7) est introduite une électrode (8) électroconductrice de telle manière que l'électrode (8) est isolée de toutes les zones du semi-conducteur.

3. Élément semi-conducteur MOS selon la revendication 2,
pour lequel
l'électrode source (S) est immédiatement voisine de la couche d'isolation de base (7), et l'électrode (8) est séparée de l'électrode source (S) seulement par la couche d'isolation de base (7).

4. Élément semi-conducteur MOS selon l'une des revendications précédentes,
pour lequel
le passage (6') entre la zone de base (1) du premier type de conduction et la zone de base (2) du deuxième type de conduction s'étend en direction verticale en se référant à la surface principale (H) horizontale de l'élément semi-conducteur MOS.
